(19)

Europäisches
Patentamt
European
Patent Office
Office européen
des brevets

(11)  **EP 2 698 920 A1**

(12)  **EUROPEAN PATENT APPLICATION**

(43) Date of publication:
 **19.02.2014  Bulletin 2014/08**

(51) Int Cl.:
 *H03L 7/08* [(2006.01)]      *H02J 3/40* [(2006.01)]

(21) Application number: **12180224.3**

(22) Date of filing: **13.08.2012**

(84) Designated Contracting States:
 **AL AT BE BG CH CY CZ DE DK EE ES FI FR GB
 GR HR HU IE IS IT LI LT LU LV MC MK MT NL NO
 PL PT RO RS SE SI SK SM TR**
 Designated Extension States:
 **BA ME**

(71) Applicant: **ABB Technology AG
 8050 Zürich (CH)**

(72) Inventors:
 • **Ho, Ngai-Man
  8050 Zürich (CH)**

 • **Escobar, Gerardo
  97115 Merida, Yucatan (MX)**
 • **Pettersson, Sami
  8050 Zürich (CH)**

(74) Representative: **Kolster Oy Ab
 Iso Roobertinkatu 23
 PO Box 148
 00121 Helsinki (FI)**

(54)  **Phase-locked loop**

(57)   A phase-locked loop for estimating a phase angle of a three-phase reference signal. The phase-locked loop comprises means for calculating an estimated first state and an estimated second state at a fundamental frequency on the basis of the reference signal and the estimated fundamental frequency, means for calculating a fundamental positive sequence component of the reference signal on the basis of the first state and the second state, means for calculating a direct component and a quadrature component in a reference frame synchronous with the phase angle on the basis of the fundamental positive sequence component and an estimated phase angle, and means for determining estimates of the estimated fundamental frequency and the estimated phase angle on the basis of the quadrature component.

Figure 1

**EP 2 698 920 A1**

**Description**

FIELD OF THE INVENTION

The present invention relates to synchronization with a three-phase reference signal, and particularly to situations where the reference signal is unbalanced and/or subject to harmonic distortion.

BACKGROUND INFORMATION

In some applications, it may be important to be able to synchronize with a reference signal. For example, in distributed power generation, grid connected power converters typically have to synchronize with the phase and frequency of a utility grid.

A phase-locked loop (PLL) can be used for synchronizing with a signal. PLLs can be formed in various ways [1]. For example, a synchronous reference frame phase-locked loop (SRF-PLL) [2] is a widely used PLL technique which is capable of detecting a phase angle and a frequency of a reference signal.

Different designs have been proposed based on the SRF-PLL approach [3]-[7]. As many other designs, the SRF-PLL is based on a linearization assumption, i.e. the results can be guaranteed locally. The SRF-PLL can yield a fast and precise detection of the phase angle, fundamental frequency and amplitude of the reference signal.

However, designs based on the SRF-PLL approach can be prone to fail due to harmonic distortion [8]-[9]. The bandwidth of the SRF-PLL feedback loop can be reduced to reject and cancel out the effect of these harmonics on the output, if the reference signal is distorted with low-order harmonics, i.e. harmonics close to the fundamental frequency. In some cases, however, reducing the PLL bandwidth may be an unacceptable solution as the speed of response of the PLL may be considerably reduced as well.

Further, unbalance in the reference signal may cause problems to designs based on the SRF-PLL approach [7], [10].

BRIEF DISCLOSURE

An object of the present invention is to provide a method and an apparatus for implementing the method so as to alleviate the above disadvantages. The objects of the invention are achieved by a method and an apparatus which are characterized by what is stated in the independent claims. Preferred embodiments of the invention are disclosed in the dependent claims.

A better tolerance for harmonic distortion and unbalance can be achieved by using a method where a fundamental positive sequence component is first calculated from the reference signal, and the positive sequence component is used to estimate the phase angle of the reference signal.

Calculation of the fundamental positive sequence component can be based on a description of a three-phase signal where the signal is described by a sum of positive and negative sequences in stationary-frame coordinates. In this manner, the fundamental positive sequence component can be extracted even under unbalanced conditions. The calculation of the fundamental positive sequence component can also include an explicit harmonic compensation mechanism (UHCM) which can deal with a possible unbalanced harmonic distortion present in the reference signal.

As a result, the calculated fundamental positive sequence component is largely free of harmonic distortion and unbalance.

The fundamental positive sequence component can then be transformed into a synchronous reference frame and a quadrature component of the positive sequence component in the synchronous reference frame can be used to estimate the fundamental frequency and the phase angle of the reference signal. The estimated fundamental frequency, in its turn, can be used in the calculation of the fundamental positive sequence component.

The disclosed method can provide clean estimates of the phase angle and the amplitude of the fundamental positive sequence component of a three-phase reference signal, even if the reference signal is subject to unbalance and harmonic distortion. The disclosed method is also robust against angular frequency variations.

BRIEF DESCRIPTION OF THE DRAWINGS

In the following, the invention will be described in greater detail by means of preferred embodiments with reference to the attached drawings, in which

Figure 1 illustrates an exemplary phase-locked loop for estimating a phase angle and amplitude of the fundamental positive sequence component of a three-phase reference signal;
Figure 2 illustrates an exemplary implementation of an unbalanced harmonics compensation mechanism;

Figures 3a to 3d illustrate a simulated transient response of the arrangement of Figures 1 and 2 to a change from balanced to unbalanced in a reference signal;

Figures 4a to 4d illustrate a simulated transient response of the exemplary arrangement of Figures 1 and 2 to harmonic distortion added to the already unbalanced reference signal;

Figures 5a to 5d illustrate a simulated transient response of the exemplary arrangement of Figures 1 and 2 to a fundamental frequency step change; and

Figures 6a to 6d illustrate a simulated transient response of an exemplary SRF-PLL algorithm to a change from balanced to unbalanced in a reference signal.

DETAILED DISCLOSURE

Knowledge about the phase angle and the amplitude of the fundamental positive sequence component of a three-phase reference signal may be required by some applications. Some applications may also require additional information, such as estimates of the angular frequency, and positive and negative sequences of the fundamental component of the reference signal. This may, for example, be the case in three-phase grid connected systems, such as power conditioning equipment, flexible ac transmission systems (FACTS), power line conditioners, regenerative drives, uninterruptible power supplies (UPS), grid connected inverters for alternative energy sources and other distributed generation and storage systems.

The present disclosure discloses a method for estimating a phase angle of a three-phase reference signal. The method can provide clean estimates of the phase angle and the amplitude of the fundamental positive sequence component of a three-phase reference signal, even when the reference signal is unbalanced and/or subject to harmonic distortion.

The disclosed method is robust against angular frequency variations, and can also provide estimates of the angular frequency, and both the positive and negative sequences of the fundamental component of the reference signal.

The disclosed method can extract a fundamental positive sequence component from the reference signal. The fundamental positive sequence component can then be transformed into a synchronous reference frame where the quadrature component of the fundamental positive sequence component can be controlled to zero in order to estimate the fundamental frequency and the phase angle of the reference signal.

Extraction of the fundamental positive sequence component can be performed on the basis of a model of an unbalanced three-phase signal. In general, a signal $v_{\alpha\beta}$ can be seen as a sum of harmonics. Thus, a description of an unbalanced three-phase signal may involve a sum of positive and negative sequences in stationary-frame coordinates.

According to [11], the following model describes a generator for a single unbalanced $k$th harmonic at a harmonic frequency $k\omega_0$ :

$$\begin{aligned} \dot{\mathbf{v}}_{\alpha\beta,k} &= k\omega_0 \mathbf{J}\boldsymbol{\varphi}_{\alpha\beta,k}, \\ \dot{\boldsymbol{\varphi}}_{\alpha\beta,k} &= k\omega_0 \mathbf{J}\mathbf{v}_{\alpha\beta,k}. \end{aligned} \tag{1}$$

The above model comprises a first state $V_{\alpha\beta,k}$ and a second state $\varphi_{\alpha\beta,k}$' where the states are represented in stationary $\alpha\beta$ coordinates. Phase variables, such as phase voltages of a three-phase grid, can be transformed into $\alpha\beta$ coordinates by using Clarke's transformation. In Equation (1), J is a transformation matrix defined as follows:

$$\mathbf{J} = \begin{bmatrix} 0 & -1 \\ 1 & 0 \end{bmatrix}. \tag{2}$$

The first state $v_{\alpha\beta,k}$ represents a sum of a positive sequence component $\mathbf{V}_{\alpha\beta,k}^{p}$ and a negative sequence component $\mathbf{V}_{\alpha\beta,k}^{n}$ of the reference signal at the harmonic frequency $k\omega_0$:

$$\mathbf{v}_{\alpha\beta,k} = \mathbf{v}_{\alpha\beta,k}^{p} + \mathbf{v}_{\alpha\beta,k}^{n}. \tag{3}$$

In other words, the first state $v_{\alpha\beta,k}$ represents the $k$th unbalanced harmonic. The second state $\varphi_{\alpha\beta,k}$ represents a difference between the positive sequence component and the negative sequence component:

$$\boldsymbol{\varphi}_{\alpha\beta,k} = \mathbf{v}_{\alpha\beta,k}^{p} - \mathbf{v}_{\alpha\beta,k}^{n}. \tag{4}$$

The model of Equation (1) forms an oscillator generating an unbalanced sinusoidal signal. In this disclosure, such an oscillator is referred to as an unbalanced harmonic oscillator (UHO).

The states of a $k$th harmonic in the reference signal can be estimated using, for example, the following estimator:

$$
\begin{aligned}
\dot{\hat{\mathbf{v}}}_{\alpha\beta,k} &= k\hat{\omega}_0 \mathbf{J}\hat{\boldsymbol{\varphi}}_{\alpha\beta,1} + \gamma_k \tilde{\mathbf{v}}_{\alpha\beta,k}, \\
\dot{\hat{\boldsymbol{\varphi}}}_{\alpha\beta,k} &= k\hat{\omega}_0 \mathbf{J}\hat{\mathbf{v}}_{\alpha\beta,k},
\end{aligned}
\tag{5}
$$

where $\hat{\mathbf{v}}_{\alpha\beta,k}$ and $\hat{\boldsymbol{\varphi}}_{\alpha\beta,k}$ are estimates of the first and the second state at the fundamental frequency, and $\tilde{\mathbf{v}}_{\alpha\beta,k}$ is a difference between the reference signal $v_{\alpha\beta}$ and the unbalanced first harmonic, i.e. the first state $\tilde{v}_{\alpha\beta,k}$. $\gamma_k$ is a design parameter which introduces the required damping.

The model of Equation (1) and the estimator of Equation (5) can be used to extract the fundamental positive sequence component, i.e. the positive sequence component $\mathbf{v}_{\alpha\beta,1}^{p}$ of the first harmonic. However, in order to apply an estimator of Equation (5), an estimate $\hat{\omega}_0$ of the fundamental frequency has to be known. Estimating the fundamental frequency will be discussed later in this disclosure.

On the basis of the reference signal $v_{\alpha\beta}$ and the estimated fundamental frequency $\hat{\omega}_0$, the disclosed method can calculate an estimated first state $\hat{v}_{\alpha\beta,1}$ of the model and an estimated second state $\hat{\varphi}_{\alpha\beta,1}$ of the model at the fundamental frequency of the reference signal $v_{\alpha\beta}$.

When values of the two estimated states are known, a fundamental positive sequence component $\hat{\mathbf{v}}_{\alpha\beta,1}^{p}$ of the reference signal $v_{\alpha\beta}$ can be calculated on the basis of the estimated first state $\hat{v}_{\alpha\beta,1}$ and the estimated second state $\hat{\varphi}_{\alpha\beta,1}$. A fundamental negative sequence component $\hat{\mathbf{v}}_{\alpha\beta,1}^{n}$ of the reference signal can also be calculated on the basis of the estimated first state $\hat{v}_{\alpha\beta,1}$ and the estimated second state $\hat{\varphi}_{\alpha\beta,1}$ of the model of an unbalanced three-phase system.

Then, a synchronous reference frame approach can be used with the fundamental positive sequence component $\hat{\mathbf{v}}_{\alpha\beta,1}^{p}$ as the new reference. On the basis of the fundamental positive sequence component $\hat{\mathbf{v}}_{\alpha\beta,1}^{p}$ and an estimated phase angle $\theta_0$, a direct component $\hat{v}_{d,1}^{p}$ and a quadrature component $\hat{v}_{q,1}^{p}$ in a rotating reference frame synchronous with the estimated phase angle can be calculated.

Finally, an estimate of an amplitude of the fundamental positive sequence component $\hat{\mathbf{v}}_{\alpha\beta,1}^{p}$ can be determined on the basis of the direct component $\hat{v}_{d,1}^{p}$, and estimates of the estimated fundamental frequency $\hat{\omega}_0$ and the estimated phase angle $\hat{\theta}_0$ can be determined on the basis of the quadrature component $\mathbf{v}_{q,1}^{p}$.

The estimated phase angle $\hat{\theta}_0$ can be determined by integrating the estimated fundamental frequency $\hat{\omega}_0$. When the estimated phase angle $\hat{\theta}_0$ follows the actual phase angle of the fundamental positive sequence component $\hat{\mathbf{v}}_{\alpha\beta,1}^{p}$

in synchrony, the magnitude of the quadrature component $\hat{v}_{q,1}^{p}$ is zero. Thus, the method may try to adjust the estimated fundamental frequency $\hat{\omega}_0$, that is, the change rate of the estimated phase angle $\hat{\theta}_0$, in order to minimize the magnitude of the quadrature component $\hat{v}_{q,1}^{p}$.

In order to deal with harmonic distortion in the reference signal $v_{\alpha\beta}$, the disclosed method can also comprise extracting harmonic contents $\hat{v}_{\alpha\beta,h}$ of the reference signal at least at one harmonic frequency other than a fundamental harmonic frequency of the reference signal. The harmonic distortion of the reference signal $v_{\alpha\beta}$ can be compensated for on the basis of the extracted harmonic content $\hat{v}_{\alpha\beta,h}$. In a manner similar to that in connection with the first harmonic, the extraction can be performed on the basis of the reference signal $v_{\alpha\beta}$, the estimated fundamental frequency $\hat{\omega}_0$, and the model of an unbalanced three-phase system.

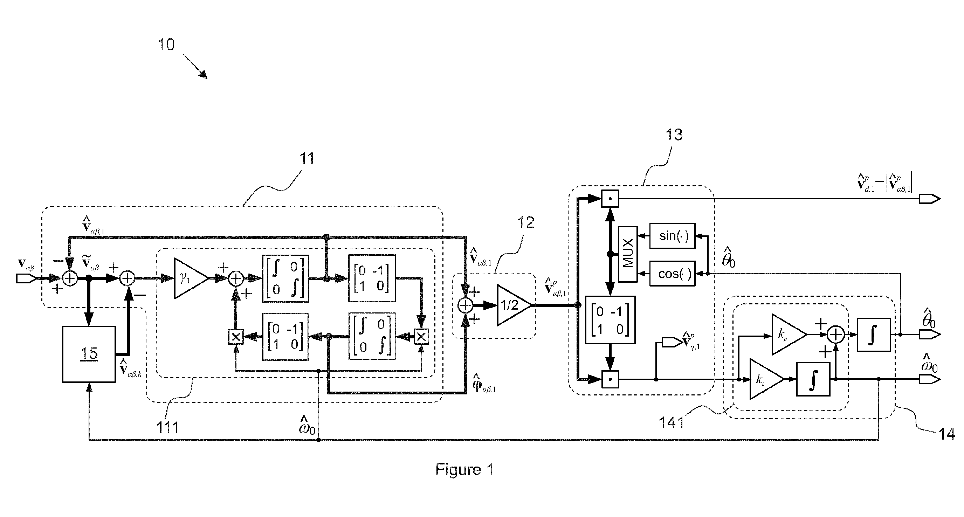

Figure 1 illustrates an exemplary phase-locked loop 10 for estimating a phase angle and the amplitude of the fundamental positive sequence component of a three-phase reference signal. In Figure 1, the phase-locked loop 10 comprises an adaptive quadrature signal generator 11, a positive sequence generator 12, a reference frame transformation block 13, a controller 14, and an unbalanced harmonic compensation mechanism 15.

The adaptive quadrature signal generator 11 acts as means for calculating an estimated first state $\hat{v}_{\alpha\beta,1}$ of the model and an estimated second state $\hat{\varphi}_{\alpha\beta,1}$ of the model at the fundamental frequency. In Figure 1, the adaptive quadrature signal generator 11 calculates the estimated first state $\hat{v}_{\alpha\beta,1}$ and the estimated second state $\hat{\varphi}_{\alpha\beta,1}$ on the basis of the reference signal $v_{\alpha\beta}$ and an estimated fundamental frequency $\hat{\omega}_0$. Following Equation 5, the adaptive quadrature signal generator 11 comprises an unbalanced harmonic oscillator 111 to which a difference $\tilde{v}_{\alpha\beta}$ between the reference signal $v_{\alpha\beta}$ and the estimated fundamental positive sequence component $\hat{\mathbf{v}}_{\alpha\beta,1}^{p}$ is fed.

The positive sequence generator 12 acts as means for calculating the fundamental positive sequence component $\hat{\mathbf{v}}_{\alpha\beta,1}^{p}$. The positive sequence generator 12 calculates the fundamental positive sequence component $\hat{\mathbf{v}}_{\alpha\beta,1}^{p}$ of the reference signal $v_{\alpha\beta}$ on the basis of the estimated first state $\hat{v}_{\alpha\beta,1}$ and the estimated second state $\hat{\varphi}_{\alpha\beta,1}$. In Figure 1, the estimated states are simply added together, and the resulting sum is divided by two.

The apparatus may also comprise means for calculating a fundamental negative sequence component $\hat{\mathbf{v}}_{\alpha\beta,1}^{n}$ of the reference signal on the basis of the estimated first state $\hat{v}_{\alpha\beta,1}$ and the estimated second state $\hat{\varphi}_{\alpha\beta,1}$ of the model of an unbalanced three-phase system. The fundamental negative sequence component $\hat{\mathbf{v}}_{\alpha\beta,1}^{n}$ can, for example, be calculated by dividing a difference between the estimated first state $\hat{v}_{\alpha\beta,1}$ and the estimated second state $\hat{\varphi}_{\alpha\beta,1}$ by two.

The reference frame transformation block 13 then calculates a direct component $\hat{v}_{d,1}^{p}$ and a quadrature component $\hat{v}_{q,1}^{p}$ in a rotating reference frame synchronous with the phase angle (dq coordinates). In Figure 1, the reference frame transformation block 13 performs the transformation on the basis of the fundamental positive sequence component $\hat{\mathbf{v}}_{\alpha\beta,1}^{p}$ and an estimated phase angle $\hat{\theta}_0$. The reference frame transformation block 13 multiplies the fundamental positive sequence component $\hat{\mathbf{v}}_{\alpha\beta,1}^{p}$ by a normalized sinusoidal vector $[\cos(\hat{\theta}_0); \sin(\hat{\theta}_0)]^{T}$ in order to transform the fundamental positive sequence component $\hat{\mathbf{v}}_{\alpha\beta,1}^{p}$ to the rotating reference frame. The controller 14 acts as means for determining the estimated phase angle $\hat{\theta}_0$. The controller 14 also determines the estimated fundamental frequency $\hat{\omega}_0$ required by the adaptive quadrature signal generator 11.

In Figure 1, the controller 14 determines estimates of the estimated fundamental frequency $\hat{\omega}_0$ and the estimated phase angle $\hat{\theta}_0$ on the basis of the quadrature component $\hat{v}_{q,1}^{p}$. When the normalized sinusoidal vector rotates at the same angular speed as the fundamental positive sequence component $\hat{\mathbf{v}}_{\alpha\beta,1}^{p}$, the magnitude of the quadrature component $\hat{v}_{q,1}^{p}$ remains constant. A non-zero quadrature component magnitude indicates a phase shift between the sinusoidal vector and the fundamental positive sequence component $\hat{\mathbf{v}}_{\alpha\beta,1}^{p}$. Thus, the controller 14 tries to minimize the magnitude of the quadrature component $\hat{v}_{q,1}^{p}$. This can be accomplished by adjusting the estimated fundamental frequency $\hat{\omega}_0$ which is then integrated into the estimated phase angle $\hat{\theta}_0$. Synchronization is achieved when magnitude of the quadrature component $\breve{v}_{q,1}^{p}$ is zeroed, i.e. when the estimated phase angle $\hat{\theta}_0$ follows the phase angle of the fundamental positive sequence component $\hat{\mathbf{v}}_{\alpha\beta,1}^{p}$.

When the magnitude of the quadrature component $\hat{v}_{q,1}^{p}$ is zero, the fundamental positive sequence component $\hat{\mathbf{v}}_{dq,1}^{p}$ in the rotating reference frame coordinates comprises only the direct component $\hat{v}_{d,1}^{p}$. Thus, the magnitude of the fundamental positive sequence component $\hat{\mathbf{v}}_{\alpha\beta,1}^{p}$ can simply be represented by the direct component $\hat{v}_{d,1}^{p}$. In other words, the reference frame transformation block 13 also acts as means for determining an estimate of an amplitude of the fundamental positive sequence component $\hat{\mathbf{v}}_{\alpha\beta,1}^{p}$ on the basis of the direct component $\hat{v}_{d,1}^{p}$.

In Figure 1, the controller 14 comprises a PI controller 141 with control *coefficients* $k_p$ and $k_i$. The estimated fundamental frequency $\hat{\omega}_0$ required by the adaptive quadrature signal generator 11 is obtained directly from the integrating part of the PI controller 141 instead of the output of the PI controller 141. In Figure 1, the output of the PI controller 141 is also affected by the proportional part of the PI controller 141. Using this output can cause higher transients and distortions on all internal signals.

In order to deal with harmonic distortion, the exemplary phase-locked loop 10 of Figure 1 comprises an unbalanced harmonic compensation mechanism (UHCM) 15.

The unbalanced harmonic compensation mechanism 15 in Figure 1 comprises means for extracting harmonic contents $\hat{v}_{\alpha\beta,h}$ of the reference signal at one or more harmonic frequencies other than a fundamental harmonic frequency of the reference signal, and means for compensating for the reference signal on the basis of the extracted harmonic content $\hat{v}_{\alpha\beta,h}$.

The harmonic contents $\hat{v}_{\alpha\beta,h}$ can be extracted on the basis of the reference signal $v_{\alpha\beta}$, the fundamental frequency $\omega_0$, and the above model of the unbalanced three-phase system, i.e. a model that comprises a first state representing a sum of a positive and a negative sequence component of the reference signal at the harmonic frequency in question, and a second state representing a difference between the positive sequence component and the negative sequence component of the reference signal at the harmonic frequency in question.

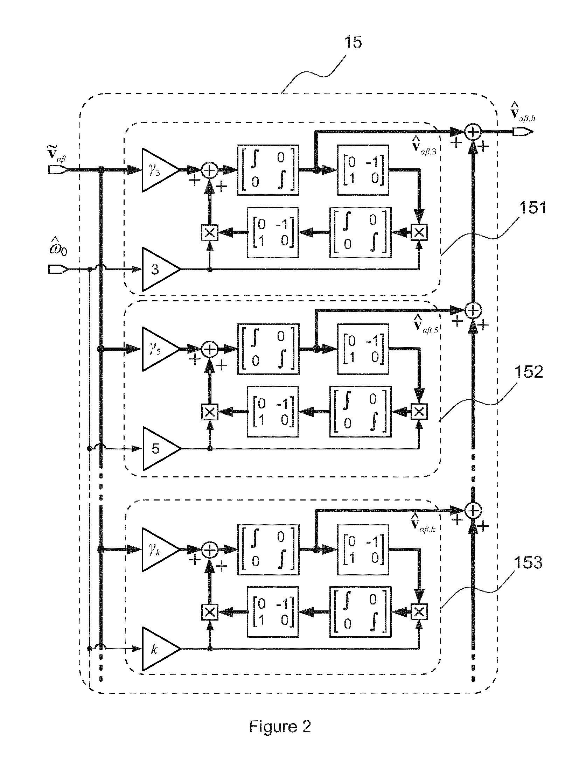

Figure 2 illustrates an exemplary implementation of the UHCM. The UHCM 15 in Figure 2 estimates selected harmonic components $\hat{v}_{\alpha\beta,h}$ of the reference signal $v_{\alpha\beta}$. The UHCM 15 is composed of a bank of harmonic oscillators (UHO), each of them tuned at the harmonics under consideration. The design of the harmonic oscillators can, for example, follow the design of the estimator given in Equation 5. In Figure 2, the topmost UHO 151 is tuned for the 3rd harmonic and the next UHO 152 for the 5th harmonic. The bottommost UHO 153 illustrates a UHO tuned at an arbitrary harmonic k. The sum $\hat{v}_{\alpha\beta,h}$ of harmonic components extracted by the UHOs can be fed back to the arrangement of Figure 1 in order to cancel their effect in the estimation of the fundamental positive sequence component $\hat{\mathbf{v}}_{\alpha\beta,1}^{p}$.

In Figure 1, the UHCM 15 appears as a plug-in block. In the case of very low harmonic distortion, the UHCM 15 can be simply eliminated. For example, if the harmonic distortion does not exceed a set limit, the UHCM 15 can be disabled, and the control effort can, thus, be reduced.

An exemplary simulation of the implementation of Figures 1 and 2 will be discussed next. Values $k_p = 10$ and $k_i = 500$ were selected for the controller 14, and a value of $\gamma_1 = 400$ was selected for the unbalanced harmonic oscillator (UHO) 111 of the adaptive quadrature signal generator 11. It was assumed that the reference signal also contained 3rd and 5th harmonics, and, thus, the UHCM 15 contained UHOs 151 and 152 tuned to these harmonics. The gains of the UHOs 151 and 152 were set to $\gamma_3 = 300$ and $\gamma_5 = 200$. The reference signal had a nominal frequency of $\omega_0 = 314.16$ rad/s (50 Hz), and an amplitude for its fundamental positive sequence of 100 V (the amplitude of the overall reference signal $v_{\alpha\beta}$ was approximately 100 V). The simulation comprised four steps.

First, in the time frame of $t = 0$ to 1 s, the setup was simulated under balanced conditions. The reference signal was formed only by a fundamental positive sequence of 100 V of amplitude. The fundamental frequency was 314.16 rad/s (50 Hz), with a zero phase shift.

Second, in the time frame of $t$ = 1 s to 2 s, the setup was simulated under unbalanced conditions. The reference signal included positive and negative sequence components. The positive sequence had an amplitude of 100 V at 314.16 rad/s (50 Hz) and a zero phase shift. For the negative sequence, an amplitude of 30 V and a phase shift of 1 rad were used.

Third, in the time frame of $t$ = 2 s to 3 s, the setup was simulated under unbalanced conditions with harmonic distortion. 3rd and 5th harmonics were added to the unbalanced signal of the second simulation step in order to create a periodic distortion. Both harmonics had also negative sequence components in order to have unbalance in the added harmonics as well.

Fourth, the setup was simulated with a frequency variation. A step change in the fundamental frequency of the reference signal was introduced at time $t$ = 3 s, changing from 314.16 rad/s (50 Hz) to 219.9 rad/s (35 Hz).

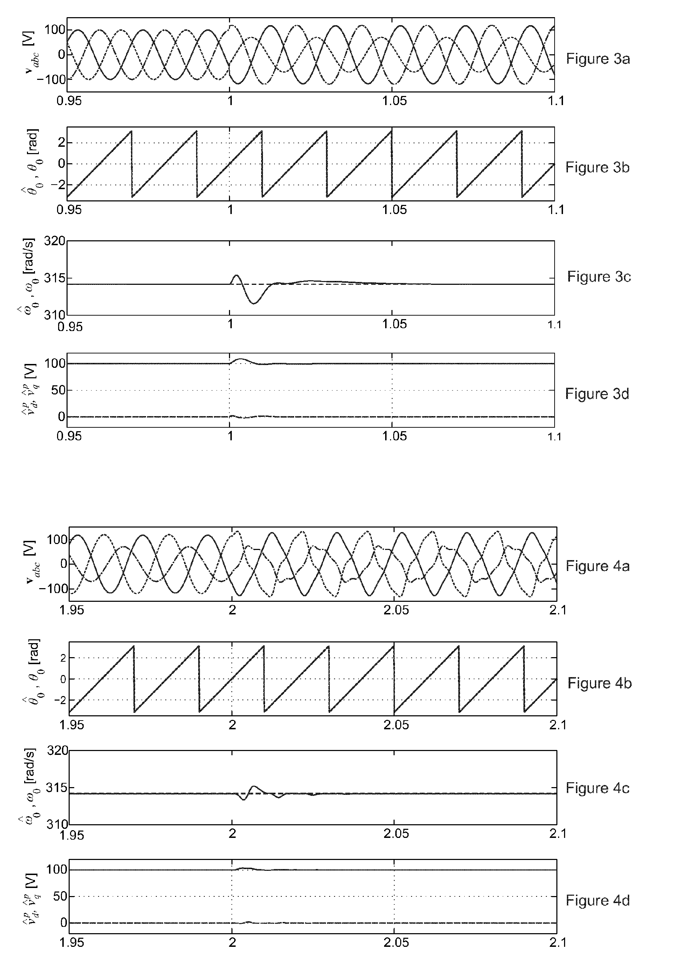

Figures 3a to 3d show a simulated transient response of the arrangement of Figures 1 and 2 to the change from balanced to unbalanced in a reference signal. In Figures 3a to 3d, 4a to 4d, 5a to 5d, and 6a to 6d, the reference signal is represented by three phase voltages v$_{abc}$. At time $t$ = 1 s, the reference signal v$_{abc}$, represented by three phase voltages in Figure 3a, is changed from balanced to unbalanced. After relatively short transients, the estimated signals in Figures 3b to 3d returned to their desired values. In Figure 3b, an estimated phase angle $\hat{\theta}_0$ (in solid line) followed an actual phase angle $\hat{\theta}_0$ (in dashed line) after almost an imperceptible transient. In Figure 3c, an estimated frequency $\hat{\omega}_0$ (solid line) closely followed a reference $\omega_0$ fixed at 316.14 rad/s (dotted line) after a small transient. In Figure 3d, the estimated $dq$ components $\hat{v}_{d,1}^{p}$ (solid line) and $\hat{v}_{q,1}^{p}$ (dashed line) of the positive-sequence of the fundamental component maintained constant values, i.e. $\hat{v}_{d}^{p}$ V and $\hat{v}_{q}^{p}$ = 0 V, after an almost imperceptible variation.

Figures 4a to 4d show the simulated transient response of the exemplary arrangement of Figures 1 and 2 to the harmonic distortion added to the already unbalanced reference signal. At time $t$ = 2 s, the harmonic distortion was added to the reference signal v$_{abc}$ in Figure 4a. After relatively short transients, the estimated signals in Figures 4b to 4d returned to their desired values.

In Figure 4c, the estimated frequency $\hat{\omega}_0$ (solid line) closely followed its reference $\omega_0$ fixed at 316.14 rad/s (dotted line) after a small transient and without further fluctuations. The estimated $dq$ components $\hat{v}_{d,1}^{p}$ (solid line) and $\hat{v}_{q,1}^{p}$ (dashed line) in Figure 4d, as well as the estimated phase angle $\hat{\theta}_0$ in Figure 4b, reached the corresponding references with an almost imperceptible transient.

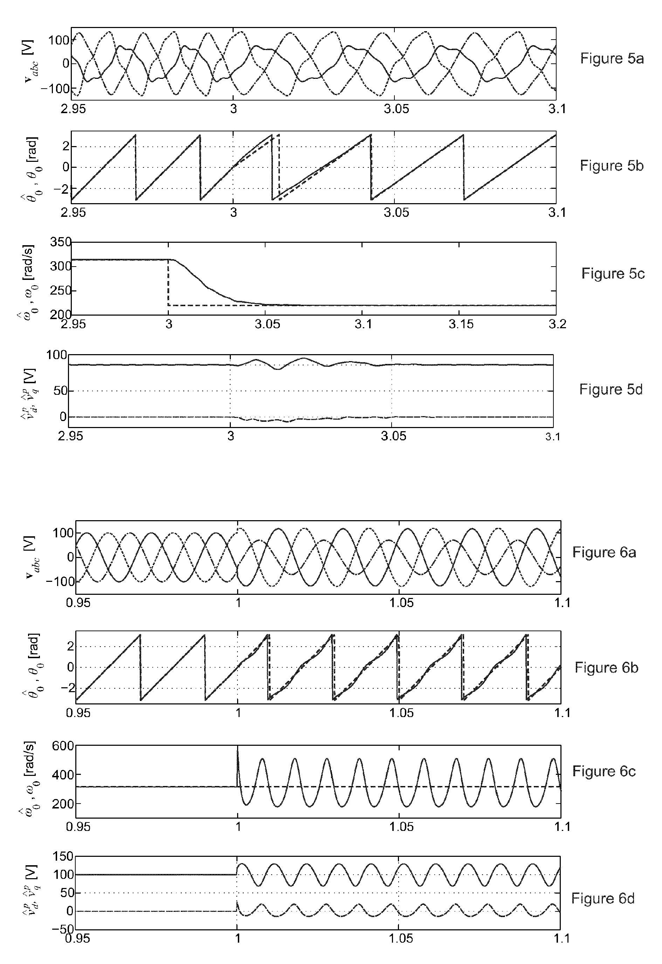

Figures 5a to 5d show a simulated transient response of the exemplary arrangement of Figures 1 and 2 to the step change in the angular frequency of the reference signal changing from $\omega_0$ = 314.16 rad/s (50 Hz) to $\omega_0$ = 219.9 rad/s (35 Hz). After a short transient, the estimated phase angle $\hat{\theta}_0$ (in solid line) in Figure 5c followed the actual phase angle $\hat{\theta}_0$ (in dashed line). The estimated fundamental frequency $\hat{\omega}_0$ in Figure 5c, starting at a reference of 314.16 rad/s (50 Hz), reached its new reference fixed at 219.9 rad/s (35 Hz) in a relatively short time. In Figure 5d, the estimated $dq$ components $\hat{v}_{d,1}^{p}$ (solid line) and $\hat{v}_{q,1}^{p}$ (dashed line) of the positive-sequence of the reference main-tained their constant values after a relatively short transient.

For comparison, an exemplary conventional SRF-PLL scheme of [2] was also simulated. The SRF-PLL was tuned to avoid excess of ripple, while still allowing for an acceptable dynamical response. Figures 6a to 6d show the transient response obtained with the SRF-PLL algorithm when the reference signal v$_{abc}$ in Figure 6a changed from a balanced to an unbalanced operation condition at time t = 1 s. Figure 6d shows a persistent fluctuation in the estimated $dq$ components $\hat{v}_{d,1}^{p}$ (solid line) and $\hat{v}_{q,1}^{p}$ dashed line) of the positive-sequence of the reference. The fluctuation in the estimated $dq$ components caused a fluctuation in the estimated fundamental frequency $\hat{\omega}_0$ in Figure 6c, which propagated to the estimated phase angle $\hat{\theta}_0$ in Figure 6b.

Figures 6a to 6d illustrate that the SRF-PLL scheme lacked means for dealing with the unbalanced operation. Similar results were obtained when harmonic distortion was added on top of the unbalance.

It will be obvious to a person skilled in the art that the inventive concept can be implemented in various ways. The invention and its embodiments are not limited to the examples described above but may vary within the scope of the claims.

REFERENCES

[1] Hsieh and J.C. Hung, "Phase-locked loop techniques - a survey," IEEE Trans. Ind. Electron., Vol. 43(6), pp. 609-615, Dec. 1996.
[2] V. Kaura and V. Blasco, "Operation of a phase locked loop system under distorted utility conditions," IEEE Trans. on Ind. Appl., Vol. 33, Issue 1, pp. 58-63, Jan./Feb. 1997.
[3] L.N. Arruda, S.M. Silva and B.J. Cardoso, "PLL structures for utility connected systems," in Proc. 36th IEEE-IAS Annual Meeting., USA, 30 Sept. - 4 Oct. 2001, Vol. 4, pp. 2655-2660.
[4] P. Rodriguez, et al., "Decoupled double synchronous reference frame PLL for Power converters control," IEEE Trans. on Ind. Electron., Vol. 22, Issue 2, pp. 584-592, March 2007.
[5] A. Ghosh, et al., "A new algorithm for the generation of reference voltages of a DVR using the method of instantaneous symmetrical components," IEEE Power Eng. Rev., Vol. 22, Issue 1, pp. 63-65, Jan. 2002.
[6] J. Svensson, "Synchronization methods for grid connected voltage source converters," Proc. Inst. Electr. Eng., Vol. 148, Issue 1, pp. 229-235, May 2001.
[7] H.S. Song, H.G. Park and K. Nam, "An instantaneous phase angle detection algorithm under unbalanced line voltage condition," Proc. 30th IEEE Power Electron. Spec. Conf. PESC 99, 27 June - 1 July 1999, Vol. 1, pp. 533-537.
[8] S.M. Silva, B.M. Lopes, B.J. Cardoso, R.P. Campana, and W.C. Boaventura, "Performance evaluation pf PLL algorithms for single-phase grid connected systems," in Proc. IEEE Ind. Appl. Annual Meeting IAS 04, Vol. 4, 2004, pp. 2259-2263.
[9] M. Karimi-Ghartemani and M.R. Iravani, "A method for synchronization of power electronic converters in polluted and variable-frequency environments," IEEE Trans. Power Syst., Vol. 19, Issue 3, pp. 1263-1270, Aug. 2004.
[10] H. Song and K. Nam, "Instantaneous phase-angle estimation algorithm under unbalanced voltage-sag conditions," Proc. Inst. Elect. Eng., Vol. 147, pp. 409-415, Nov. 2000.
[11] G. Escobar, S. Pettersson and C.N.M. Ho, "Phase-locked loop for grid synchronization under unbalanced operation and harmonic distortion," in Proc. Industrial Electronics Conf. IECON11, Melbourne, Nov. 2011, Vol. 1, pp. 623-628.

**Claims**

1. A phase-locked loop (10) for estimating a phase angle of a three-phase reference signal ($v_{\alpha\beta}$), wherein the phase-locked loop (10) comprises means (11) for calculating an estimated first state ($\hat{v}_{\alpha\beta,1}$) and an estimated second state ($\hat{\varphi}_{\alpha\beta,1}$) of a model of an unbalanced three-phase system at a fundamental frequency of the reference signal on the basis of the reference signal ($v_{\alpha\beta}$) and an estimated fundamental frequency ($\hat{\omega}_0$), wherein the model comprises a first state representing a sum of a positive and a negative sequence component of the reference signal at a harmonic frequency, and a second state representing a difference between the positive sequence component and the negative sequence component,

   means (12) for calculating a fundamental positive sequence component ($\hat{\mathbf{v}}_{\alpha\beta,1}^{p}$) of the reference signal on the basis of the estimated first state ($\hat{v}_{\alpha\beta,1}$) and the estimated second state ($\hat{\varphi}_{\alpha\beta,1}$),

   means (13) for calculating a direct component ($\hat{v}_{d,1}^{p}$) and a quadrature component ($\hat{v}_{q,1}^{p}$) in a rotating reference frame synchronous with the estimated phase angle ($\hat{\theta}_0$) on the basis of the fundamental positive sequence component ($\hat{\mathbf{v}}_{\alpha\beta,1}^{p}$) and an estimated phase angle ($\hat{\theta}_0$),

   means (13) for determining an estimate of an amplitude of the fundamental positive sequence component ($\hat{\mathbf{v}}_{\alpha\beta,1}^{p}$) on the basis of the direct component ($\hat{v}_{d,1}^{p}$), and

   means (14) for determining estimates of the estimated fundamental frequency ($\hat{\omega}_0$) and the estimated phase angle ($\hat{\theta}_0$) on the basis of the quadrature component ($\hat{v}_{q,1}^{p}$).

2. A phase-locked loop according to claim 1, wherein the phase-locked loop comprises
means (15) for extracting harmonic contents ($\hat{v}_{\alpha\beta,h}$) of the reference signal ($v_{\alpha\beta}$) at least at one harmonic frequency other than a fundamental harmonic frequency of the reference signal ($v_{\alpha\beta}$) on the basis of the reference signal ($v_{\alpha\beta}$), the estimated fundamental frequency ($\hat{\omega}_0$), and the model of an unbalanced three-phase system, and
means (15) for compensating for the reference signal ($v_{\alpha\beta}$) on the basis of the extracted harmonic content ($\hat{v}_{\alpha\beta,h}$).

3. A phase-locked loop according to claim 1 or 2, wherein the phase locked loop (10) comprises

means for calculating a fundamental negative sequence component $\left( \hat{\mathbf{v}}_{\alpha\beta,1}^{n} \right)$ of the reference signal ($v_{\alpha\beta}$) on the basis of the estimated first state ($\hat{v}_{\alpha\beta,1}$) and the estimated second state ($\hat{\varphi}_{\alpha\beta,1}$) of the model of an unbalanced three-phase system.

4. A phase-locked loop according to any one of claims 1 to 3, wherein the means (14) for determining estimates of the estimated fundamental frequency ($\hat{\omega}_0$) and the estimated phase angle ($\hat{\theta}_0$) comprise a controller minimizing the magnitude of the quadrature component $\left( \hat{v}_{q,1}^{p} \right)$.

5. A phase-locked loop according to claim 4, wherein the controller comprises a PI controller (141) and the estimated fundamental frequency ($\hat{\omega}_0$) is obtained directly from an integrating part of the PI controller (141).

6. A phase-locked loop according to claim 2, wherein the means (15) for extracting the harmonic contents and the means (15) for compensating for the reference signal are configured to be disabled if harmonic distortion does not exceed a set limit.

7. A method for estimating a phase angle of a three-phase reference signal ($v_{\alpha\beta}$), wherein the method comprises
calculating an estimated first state ($\hat{v}_{\alpha\beta,1}$) and an estimated second state ($\hat{\varphi}_{\alpha\beta,1}$) of a model of an unbalanced three-phase system at s fundamental frequency of the reference signal on the basis of the reference signal ($v_{\alpha\beta}$) and an estimated fundamental frequency ($\hat{\omega}_0$), wherein the model comprises a first state representing a sum of a positive and a negative sequence component of the reference signal at a harmonic frequency, and a second state representing a difference between the positive sequence component and the negative sequence component,

calculating a fundamental positive sequence component $\left( \hat{\mathbf{v}}_{\alpha\beta,1}^{p} \right)$ of the reference signal on the basis of the estimated first state ($\hat{v}_{\alpha\beta,1}$) and the estimated second state ($\hat{\varphi}_{\alpha\beta,1}$),

calculating a direct component $\left( \hat{v}_{d,1}^{p} \right)$ and a quadrature component $\left( \hat{v}_{q,1}^{p} \right)$ in a rotating reference frame synchronous with the estimated phase angle ($\hat{\theta}_0$) on the basis of the fundamental positive sequence component $\left( \hat{\mathbf{v}}_{\alpha\beta,1}^{p} \right)$ and an estimated phase angle ($\hat{\theta}_0$),

determining an estimate of an amplitude of the fundamental positive sequence component $\left( \hat{\mathbf{v}}_{\alpha\beta,1}^{p} \right)$ on the basis of the direct component $\left( \hat{v}_{d,1}^{p} \right)$, and

determining estimates of the estimated fundamental frequency ($\hat{\omega}_0$) and the estimated phase angle ($\hat{\theta}_0$) on the basis of the quadrature component $\left( \hat{v}_{q,1}^{p} \right)$.

Figure 1

Figure 2

Figure 3a

Figure 3b

Figure 3c

Figure 3d

Figure 4a

Figure 4b

Figure 4c

Figure 4d

Figure 5a

Figure 5b

Figure 5c

Figure 5d

Figure 6a

Figure 6b

Figure 6c

Figure 6d

Europäisches
Patentamt

European
Patent Office

Office européen
des brevets

# EUROPEAN SEARCH REPORT

Application Number

EP 12 18 0224

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2009/105979 A1 (ESCOBAR VALDERRAMA GERARDO [MX] ET AL) 23 April 2009 (2009-04-23) * paragraph [0046] - paragraph [0055]; figure 2 * | 1-7 | INV. H03L7/08 H02J3/40 |
| A | WO 2010/051810 A1 (VESTAS WIND SYS AS [DK]; RODRIGUEZ PEDRO [ES]; TEODORESCU REMUS [DK]) 14 May 2010 (2010-05-14) * the whole document * | 2 | |
| A | WO 2008/055499 A2 (UNIV AALBORG [DK]; TEODORESCU REMUS [DK]; RODRIGUEZ PEDRO [ES]) 15 May 2008 (2008-05-15) * the whole document * | 1-7 | |

TECHNICAL FIELDS
SEARCHED (IPC)

H03L
G01R
H02J

The present search report has been drawn up for all claims

| Place of search | Date of completion of the search | Examiner |
|---|---|---|
| The Hague | 28 February 2013 | Peeters, Mark |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 12 18 0224

This annex lists the patent family members relating to the patent documents cited in the above-mentioned European search report.
The members are as contained in the European Patent Office EDP file on
The European Patent Office is in no way liable for these particulars which are merely given for the purpose of information.

28-02-2013

| Patent document cited in search report | Publication date | Patent family member(s) | Publication date |
|---|---|---|---|
| US 2009105979 A1 | 23-04-2009 | NONE | |
| WO 2010051810 A1 | 14-05-2010 | CN 102483432 A<br>EP 2359151 A1<br>US 2011285380 A1<br>WO 2010051810 A1 | 30-05-2012<br>24-08-2011<br>24-11-2011<br>14-05-2010 |
| WO 2008055499 A2 | 15-05-2008 | CN 101617234 A<br>EP 2089725 A2<br>US 2010213925 A1<br>WO 2008055499 A2 | 30-12-2009<br>19-08-2009<br>26-08-2010<br>15-05-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **HSIEH ; J.C. HUNG.** Phase-locked loop techniques - a survey. *IEEE Trans. Ind. Electron.,* December 1996, vol. 43 (6), 609-615
- **V. KAURA ; V. BLASCO.** Operation of a phase locked loop system under distorted utility conditions. *IEEE Trans. on Ind. Appl.,* January 1997, vol. 33 (1), 58-63
- **L.N. ARRUDA ; S.M. SILVA ; B.J. CARDOSO.** PLL structures for utility connected systems. *Proc. 36th IEEE-IAS Annual Meeting., USA,* 30 September 2001, vol. 4, 2655-2660
- **P. RODRIGUEZ et al.** Decoupled double synchronous reference frame PLL for Power converters control. *IEEE Trans. on Ind. Electron.,* March 2007, vol. 22 (2), 584-592
- **A. GHOSH et al.** A new algorithm for the generation of reference voltages of a DVR using the method of instantaneous symmetrical components. *IEEE Power Eng. Rev.,* January 2002, vol. 22 (1), 63-65
- **J. SVENSSON.** Synchronization methods for grid connected voltage source converters. *Proc. Inst. Electr. Eng.,* May 2001, vol. 148 (1), 229-235

- **H.S. SONG ; H.G. PARK ; K. NAM.** An instantaneous phase angle detection algorithm under unbalanced line voltage condition. *Proc. 30th IEEE Power Electron. Spec. Conf. PESC 99,* 27 June 1999, vol. 1, 533-537
- **S.M. SILVA ; B.M. LOPES ; B.J. CARDOSO ; R.P. CAMPANA ; W.C. BOAVENTURA.** Performance evaluation pf PLL algorithms for single-phase grid connected systems. *Proc. IEEE Ind. Appl. Annual Meeting IAS 04,* 2004, vol. 4, 2259-2263
- **M. KARIMI-GHARTEMANI ; M.R. LRAVANI.** A method for synchronization of power electronic converters in polluted and variable-frequency environments. *IEEE Trans. Power Syst.,* August 2007, vol. 19 (3), 1263-1270
- **H. SONG ; K. NAM.** Instantaneous phase-angle estimation algorithm under unbalanced voltage-sag conditions. *Proc. Inst. Elect. Eng.,* November 2000, vol. 147, 409-415
- **G. ESCOBAR ; S. PETTERSSON ; C.N.M. HO.** Phase-locked loop for grid synchronization under unbalanced operation and harmonic distortion. *Proc. Industrial Electronics Conf. IECON11, Melbourne,* November 2011, vol. 1, 623-628